# EUROPEAN PATENT SPECIFICATION

(11) **EP 3 008 022 B1**
(45) Date of publication and mention of the grant of the patent: **30.12.2020**
(21) Application number: 14735816.2
(22) Date of filing: 13.06.2014
(51) Int. Cl.: C03C 3/091, C03C 27/06, B32B 17/06, C03C 8/24, C03C 23/00, C03B 17/02, C03B 17/06, C03B 23/203, H01L 51/52, B23K 26/20

(54) **LAMINATED SEALING SHEET**
LAMINIERTE DICHTUNGSFOLIE
FEUILLE STRATIFIÉE D'ÉTANCHÉITÉ

(30) Priority: 14.06.2013 US 201361835120 P
(43) Date of publication of application: 20.04.2016
(73) Proprietor: Corning Incorporated, Corning, New York 14831 (US)
(72) Inventor: EDWARDS, Victoria Ann, Las Cruces, New Mexiko 88011 (US)
(74) Representative: Elkington and Fife LLP
(86) International application number: PCT/US2014/042230
(87) International publication number: WO 2014/201315

(56) References cited:
- WO-A1-2013/016157
- WO-A1-2014/134098
- US-A1- 2004 197 575
- US-A1- 2005 116 245
- US-A1- 2006 127 679
- US-A1- 2011 001 424
- US-A1- 2011 223 360

## Description

### BACKGROUND

### Field

The present specification generally relates to laminated sealing sheets and more specifically to a laminated sealing sheets used in glass-to-glass sealing to form hermetically sealed glass packages.

### Technical Background

Hermetic glass-to-glass seals may be used in many industries, such as, display technologies, semiconductor technologies, lighting technologies, and photovoltaic technologies. Historically, some hermetic glass-to-glass sealing processes utilized elevated temperatures during the sealing process, which can lead to damage of the resultant sealed product. For example, in sealing organic light emitting devices/diodes (OLEDs), sealing processes that transfer excessive heat to the active organic layer can damage the active organic layer. In addition, OLEDs can be susceptible to environmental degradation from exposure to water vapor, oxygen, or both, which can be deleterious to the organic material and the electrical components of the OLED structure.

To minimize excessive heat transfer and environmental contaminations, laser-frit sealing, laser direct-glass sealing, and thin-film low-melting glass sealing have been employed. Laser frit sealing can add the cost of having to pattern the frit line before applying the laser or of having to apply a layer of frit to the sheet. Direct-glass-sealing can suffer from the disadvantages of poor optical transmission through the sealing sheet and the high cost of making exotic (expensive) laser-absorbing glass. The thin-film low-melting glass sealing involves a thin film sealing layer that is typically from about 0.5 to about 2.0 microns in thickness being applied to an exterior glass carrier surface. Therefore, the thin film material is not fusion formable and is supplied by sputter coating onto the glass carrier, which can add cost to sputter coat the material onto glass, especially since sputtering is an inherently slow process and large vacuum equipment may be required. In addition, the thin film sealing can be subject to damage, such as scratching or delamination. Glass-to-glass sealing may also be done with polymeric or filled polymeric materials, but these seals may not provide the degree of hermeticity needed for certain applications. Glass seals can also be created by anodic bonding, but this can require high voltages, which would not be suitable for applications having electronic circuits already patterned on the glass.

Alternative approaches for glass-to-glass sealing are disclosed herein.

US 2005/0116245 A1 discloses a hermetically sealed glass package.

US 2004/0197575 A1 discloses a laminated sheet including a surface layer having an optical surface.

### SUMMARY

In a first aspect of the invention, there is provided a glass sealing sheet as defined in claim 1.

In a second aspect, there is provided a glass package as defined in claim 7.

In a third aspect, a method of manufacturing a glass sealing sheet is provided as defined in claim 10.

In a forth aspect, there is provided a method of manufacturing a glass package as defined in claim 8.

Additional features and advantages of the embodiments will be set forth in the detailed description which follows, and in part will be readily apparent to those skilled in the art from that description or recognized by practicing the embodiments described herein, including the detailed description which follows, the claims, as well as the appended drawings.

It is to be understood that both the foregoing general description and the following detailed description describe various embodiments and are intended to provide an overview or framework for understanding the nature and character of the claimed subject matter. The accompanying drawings are included to provide a further understanding of the various embodiments, and are incorporated into and constitute a part of this specification. The drawings illustrate the various embodiments described herein, and together with the description serve to explain the principles and operations of the claimed subject matter.

### BRIEF DESCRIPTION OF THE DRAWINGS

In embodiments:
FIG. 1 schematically depicts an exemplary glass sealing sheet;
FIG. 2 schematically depicts an exemplary method of manufacturing a glass sealing sheet;
FIG. 3 schematically depicts an exemplary method of manufacturing a glass sealing sheet;
FIG. 4 schematically depicts an exemplary method of manufacturing a glass package.

### DETAILED DESCRIPTION

Reference will now be made in detail to embodiments of glass sealing sheets, methods for manufacturing glass sealing sheets, glass packages, and methods for manufacturing glass packages, examples of which are illustrated in the accompanying drawings. In embodiments herein, glass sealing sheets for sealing OLEDs and glass packages comprising glass sealing sheets and OLEDs are set forth in significant detail. It is noted, however, that this is merely an illustrative implementation of the embodiments disclosed herein. The embodiments are applicable to other technologies that are susceptible to similar problems as those discussed above. For example, embodiments for sealing electronic and photonic devices and structures are clearly within the purview of the present embodiments. These may include, but are not limited to, integrated circuits and semiconductor structures. Moreover, the example embodiments are applicable in other types of optical devices besides OLED displays including field emission displays, plasma displays, inorganic electroluminescent (EL) displays, and other optical devices where sensitive films have to be protected from the environment. Whenever possible, the same reference numerals will be used throughout the drawings to refer to the same or like parts.

The term "substantially free," when used to describe the absence of a particular component in a glass composition, means that the component is present in the glass composition as a contaminant in a trace amount of less than 0.1 mol. %.

In embodiments herein, glass sealing sheets are disclosed comprising a glass core layer having a first side and a second side, and a first cladding layer fused to the first side of the glass core layer. Additionally,the glass sealing sheets comprise a second cladding layer fused to the second side of the glass core layer. In embodiments herein, methods of manufacturing glass sealing sheets comprise melting a core glass composition to form a molten core glass composition, melting a first cladding glass composition comprising radiation absorbing constituents to form a molten first cladding glass composition, flowing the molten core glass composition and the molten first cladding glass composition such that they converge and form a composite flow, and drawing the composite flow into a glass sealing sheet. Additionally, the methods of manufacturing glass sealing sheets comprise melting a second cladding composition to form a molten second cladding composition, flowing the molten core glass composition, the molten first cladding glass composition, and the molten second cladding composition such that they converge and form a composite flow, and drawing the composite flow into a glass sealing sheet.

In embodiments herein, a glass package is disclosed comprising a glass sealing sheet, and a glass substrate sealed to the glass sealing sheet such that a hermetic seal is substantially created. In embodiments herein, methods of manufacturing a glass package comprise placing a glass sealing sheet in contact with a glass substrate, and irradiating a predetermined sealing area along the glass sealing sheet with a laser to form a substantially hermetically sealed glass package.

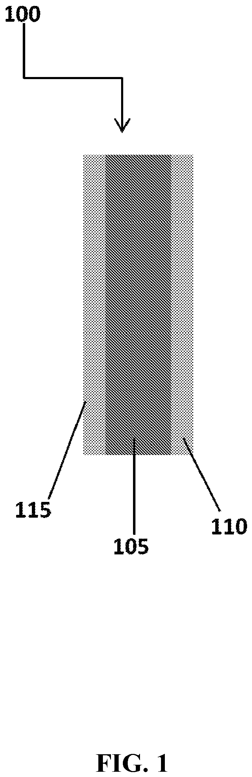

Referring to FIG. 1, depicted is a schematic view of an exemplary embodiment of a glass sealing sheet **100** comprising a glass core layer **105** having a first side and a second side, a first cladding layer **110** bonded or fused to the first side of the glass core layer **105,** and a second cladding layer **115** bonded or fused to the second side of the glass core layer **105.** The interfaces between the first cladding layer **110** and the glass core layer **105** and/or between the second cladding layer **115** and the glass core layer **105** can be free of any bonding material such as, for example, an adhesive, a coating layer, or any non-glass material added or configured to adhere the respective cladding layers to the glass core layer. Thus, the first cladding layer **110** and/or the second cladding layer **115** are fused directly to the glass core layer **105** or are directly adjacent to the glass core layer **105.** In some embodiments, the glass sealing sheet comprises one or more intermediate layers disposed between the glass core layer and the first cladding layer and/or between the glass core layer and the second cladding layer. For example, the intermediate layers comprise intermediate glass layers and/or diffusions layers formed at the interface of the glass core layer and the cladding layer (e.g., by diffusion of one or more components of the glass core and cladding layers into the diffusion layer). In some embodiments, the glass sealing sheet **100** comprises a glass-glass laminate (e.g., an in situ fused multilayer glass-glass laminate) in which the interfaces between directly adjacent glass layers are glass-glass interfaces.

The glass core layer **105** described herein may be formed from or comprises a glass composition that includes, for example, soda-lime glass, silicate glass, borosilicate glass, aluminosilicate glass, aluminoborosilicate glass, alkaline-earth aluminoborosilicate glass, or other suitable laminate formable glasses. In some embodiments, the glass core layer **105** may be an alkaline-earth aluminoborosilicate glass. The glass core layer **105** is substantially free of radiation absorbing constituents, and is selected such that it is non-absorbing of radiation at an emission wavelength of a laser, for example, or over emission wavelength ranges of lasers used to effect the sealing by heating of the glass sealing sheet **100.** In some embodiments, the glass core layer **105** is at least partially transparent.

The dimensions of the glass core layer **105** described herein can be any dimensions suitable for the glass sealing sheet **100** to produce a sealed package. In some embodiments, the glass core layer **105** has a thickness ranging from about 100 microns to about 900 microns. In other embodiments, the glass core layer **105** has a thickness ranging from about 200 microns to about 700 microns. In other embodiments, the glass core layer **105** has a thickness ranging from about 250 microns to about 500 microns.

The glass core layer **105** described herein may have a core coefficient of thermal expansion ("CTE") of from about 0×10⁻⁷/°C to about 100×10⁻⁷/°C. In some embodiments, the glass core layer **105** may have a core CTE of from about 25×10⁻⁷/°C to about 80×10⁻⁷/°C. In further embodiments, the glass core layer **105** may have a core CTE of from about 50×10⁻⁷/°C to about 80×10⁻⁷/°C.

The first cladding layer **110** described herein comprises a glass composition comprising radiation absorbing constituents. Thus, the first cladding layer **110** may be absorbing of radiation at an emission wavelength or over at least a portion of an emission wavelength range. The first cladding layer **110** has a first coefficient of thermal expansion. In some embodiments, the first cladding layer **110** is substantially transparent.

The second cladding layer **115** described herein comprises a polymer composition comprising radiation absorbing constituents. Thus, the second cladding layer **115** may be absorbing of radiation at an emission wavelength or over at least a portion of an emission wavelength range. The second cladding layer **115** has a second coefficient of thermal expansion. In some embodiments, the second cladding layer **115** is substantially transparent.

The differential between the first CTE and the second CTE ranges from about 0x10⁻⁷/°C to about 10x10⁻⁷/°C, or from about 0x10⁻⁷/°C to about 5x10⁻⁷/°C, in other embodiments. Low or no CTE differentials between the cladding layers can prevent warpage due to the asymmetry of the compressive forces that may occur in glasses with mismatched coefficients of thermal expansion.

The core CTE of the glass core layer **105** may range from about 0x10⁻⁷/°C to about 50x10⁻⁷/°C greater than the first CTE and/or the second CTE. In some embodiments, the core CTE of the glass core layer **105** may range from about 25x10⁻⁷/°C to about 50x10⁻⁷/°C greater than the first CTE and the second CTE. A differential between the core CTE and the first and second CTE can result in the first cladding layer **110** and the second cladding layer **115** being compressively stressed without being ion exchanged or thermally tempered, thus imparting damage-resistance to the glass sealing sheet **100.** The glass sealing sheet **100** may have a compressive stress greater than about 20 MPa. For example, the glass sealing sheet **100** may have a compressive stress ranging from about 25 MPa to about 400 MPa in some embodiments, from about 25 MPa to about 250 MPa in other embodiments, and from about 75 Mpa to about 200 Mpa in other embodiments. There also may be little to no differential between the core CTE of the glass core layer **105** and the first CTE and the second CTE. In some embodiments the differential between the core CTE of the glass core layer **105** and the first CTE and the second CTE may range from about 0x10⁻⁷/°C to about 10x10⁻⁷/°C.

Suitable glass compositions that may be used to form the first cladding layer 110 may include, but are not limited to, silicate glass, borosilicate glass, aluminosilicate glass, aluminoborosilicate glass, alkaline-earth aluminoborosilicate glass, phosphate glass, or other suitable laminate formable glasses. In some embodiments, the first cladding layer 110 may be an aluminoborosilicate glass.

Polymeric compositions used as lower processing temperatures are employed in forming the glass sealing sheet **100,** and low birefringence is desired. Suitable polymer compositions that may be used to form the second cladding layer 115 may include, but are not limited to, damage-resistant polymers, for example, acrylates, polycarbonates, styrenes, or other suitable polymers that provide damage resistance.

The first cladding layer **110** and second cladding layer **115** are doped with one or more radiation absorbing constituents using known doping techniques. The radiation absorbing constituents used in the first cladding layer **110** and second cladding layer **115** comprise at least one transition metal or rare earth element selected from the group consisting of iron, copper, vanadium, manganese, cobalt, nickel, chromium, neodymium, cerium, and combinations thereof. In other embodiments, the radiation absorbing constituents comprise cerium. As mentioned, the source of the radiation may be a laser. For purposes of illustration, cerium-containing glasses can have a strong absorption at 355 nm and may successfully seal using a pulsed 355 nm laser.

The radiation absorbing constituents are selected such that at a certain wavelength or over a certain wavelength range, melting of the first cladding layer **110** occurs. To this end, it is useful to choose radiation absorbing constituents that absorb at least approximately 30 percent of the energy of the radiation at the wavelength or over emission wavelength ranges of the radiation. In some embodiments, the radiation absorbing constituents absorb at least approximately 65 percent of the energy of the radiation at a wavelength or over emission wavelength ranges of the radiation. In addition, it is noted that absorption of less than approximately 25 percent of the radiation energy is insufficient to adequately affect the sealing, and may degrade other components such as conductive materials used for electrodes on the sheet to be sealed. Further, electromagnetic radiation of various wavelengths or wavelength bands may be used. These may include, but are not limited to microwave radiation, millimeter radiation and ultra-violet radiation, and/or infrared radiation.

The amount of radiation absorbing constituents present in the composition of the first cladding layer **110** and/or second cladding layer **115** may vary, and should be present in an amount sufficient to absorb enough radiation to effectively melt and provide hermetic glass-to-glass sealing. In some embodiments, the radiation absorbing constituents are present in the composition from about 0.1 mol.% to about 10 mol.%, from about 0.25 mol.% to about 7.5 mol.%, or from about 0.50 mol.% to about 5 mol.%.

In some embodiments, the glass composition of the first cladding layer **110** may comprise:
from about 50 mol.% to about 75 mol.% SiO₂;
from about 1 mol.% to about 20 mol.% Al₂O₃;
from about 8 mol.% to about 30 mol.% B₂O₃;
from about 0 mol.% to about 6 mol.% Na₂O;
from about 0 mol.% to about 2 mol.% Li₂O;
from about 0 mol.% to about 3 mol.% K₂O;
from about 0.5 mol.% to about 5 mol.% radiation absorbing constituents; and
from about 0 mol.% to about 5 mol.% TiO₂.

While exemplary glass compositions have been described hereinabove with reference to specific compositional ranges for various constituent components (such as SiO₂, Al₂O₃, and the like), it should be understood that each compositional range of each constituent component may include one or more narrower compositional ranges for that constituent component in order to produce a glass having the desired properties.

The dimensions of the first cladding layer **110** described herein can be any dimension suitable for the glass sealing sheet **100** being fabricated. In some embodiments, the first cladding layer **110** has a thickness ranging from about 20 microns to about 200 microns. In other embodiments, the first cladding layer **110** has a thickness ranging from about 30 microns to about 150 microns. Similarly, the second cladding layer **115** described herein can be any dimension suitable for the glass sealing sheet **100** being fabricated. In some embodiments, the second cladding layer **115** has a thickness ranging from about 20 microns to about 200 microns. In other embodiments, the second cladding layer **115** has a thickness ranging from about 30 microns to about 150 microns. The total thickness of the glass sealing sheet **100** may be less than about 1 mm.

The glass sealing sheet **100** may be formed by, for example, a fusion process. In some embodiments, glass sealing sheets **100** described herein may be formed by a fusion lamination process such as the process described in U.S. Patent No. 4,214,886. The glass sealing sheet **100** may also be formed by, for example, a slot draw lamination process.

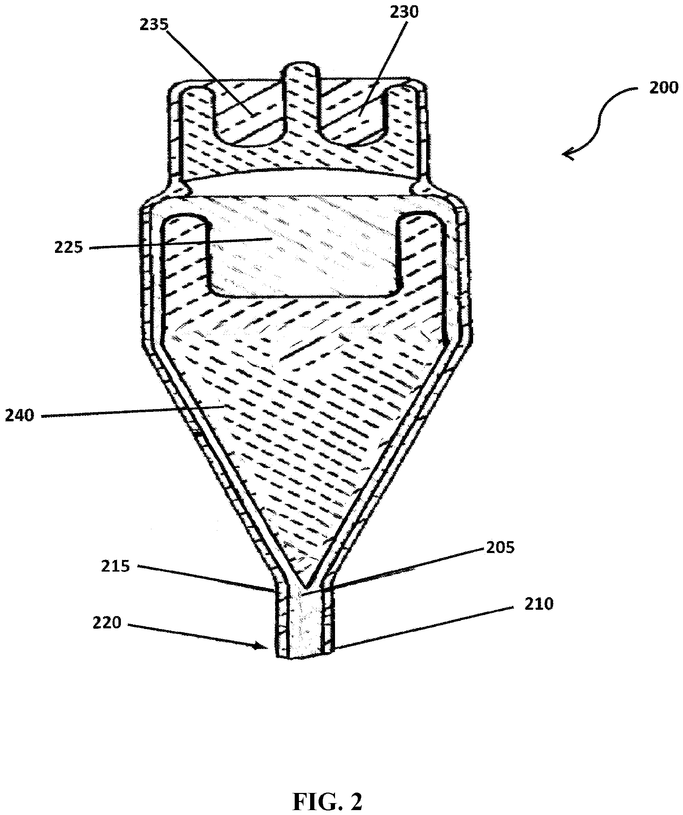

Referring to FIG. 2, an example of a fusion lamination process **200** not in accordance with the invention is depicted. The core glass composition, which forms the glass core layer **205,** the first cladding glass composition, which forms the first cladding layer **210,** and the second cladding glass composition, which forms the second cladding layer **215,** are separately melted and delivered through an appropriate delivery system to a corresponding overflow distributor **225, 230, 235,** respectively. The overflow distributors **230, 235** includes a central wall that allows for two different glass compositions to be used in forming the first cladding layer **210** and second cladding layer **215.** The overflow distributors **230, 235** are mounted above the overflow distributor **225** so that the glass from the overflow distributors **230, 235** flows over top edge portions of the overflow distributors **230, 235** and down the sides to form a uniform flow layer of appropriate thickness on both sides of the overflow distributors **230, 235** below such top edge portions. Asymmetric layer thicknesses are achievable by adjusting the relative glass flow over the two sides of any given overflow distributor (and associated forming member) such as by tilting the forming member, or a combination thereof.

The overflow distributor **225** has a wedge-shaped forming member **240** associated therewith. The forming member **240** has converging sidewall portions which communicate at their top end with the sidewalls of the overflow distributor **225** and terminate at their converging bottom ends in a draw line. The molten core glass overflowing the overflow distributor **225** flows downwardly along the distributor walls and forms an initial glass flow layer adjacent to the converging outer surfaces of the forming member **240,** whereas the molten first and second cladding glass overflowing the overflow distributors **230, 235** from above flows downwardly over the distributor walls and flows over outer surface portions of the glass core layer **205,** thereby fusing together and creating a glass composite flow **220.** The two individual layers of core glass from each converging sidewall of the forming member **240** are brought together and fused to form the glass core layer **205,** which is located between the first cladding layer **210** and second cladding layer **215.** The dimensional control and resulting pristine glass surface conditions can make the fusion, or overflow process, a satisfactory method for making glass sealing sheets.

In an exemplary method of manufacturing glass sealing sheets, a core glass composition is melted in a core melting vessel to form a molten core glass composition, a first cladding glass composition comprising radiation absorbing constituents is melted in a first melting vessel to form a molten first cladding glass composition, and a second cladding polymer composition is melted in a second melting vessel to form a molten second cladding polymer composition. The molten glass compositions are delivered to a forming apparatus where the molten core glass composition and the molten first cladding glass composition flow such that they converge to form a single glass composite flow, and the glass composite flow and the molten second cladding polymer composition flow such that they converge and form a composite flow. The molten glass streams fuse into a single glass composite flow. The composite flow is drawn into a glass sealing sheet having a final desired thickness.

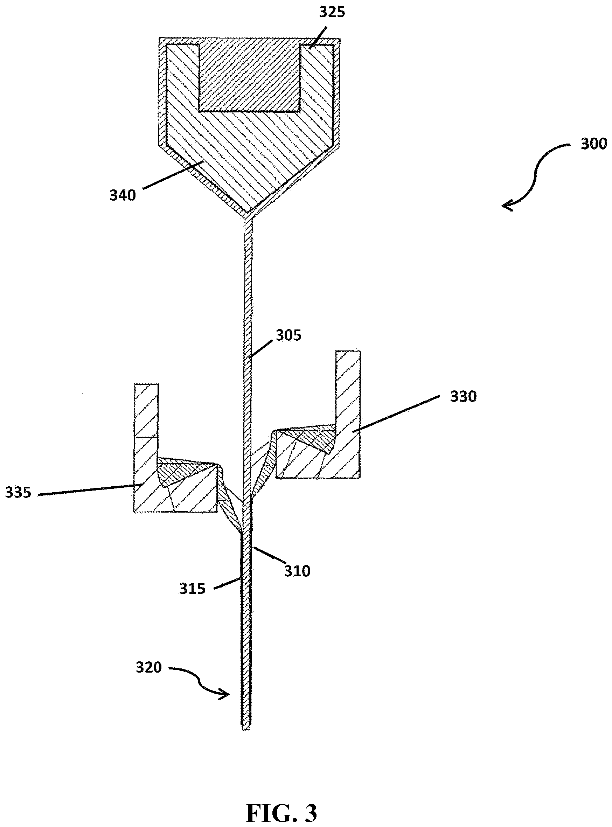

Referring to FIG. 3, an example of a fusion lamination process **300** is depicted. The core glass composition, which forms the glass core layer **305,** the first cladding glass composition, which forms the first cladding layer **310,** and the second cladding polymer composition, which forms the second cladding layer **315,** are separately melted and delivered through an appropriate delivery system to a corresponding overflow distributors **325, 330, 335,** respectively. Single-sided overflow distributors **330, 335** allows for two different compositions to be used in forming the first cladding layer **310** and second cladding layer **315.**

The single-sided overflow distributors **330, 335** are positioned at different heights below the overflow distributor **325.** The compositions from the overflow distributors **330, 335** flow over a top edge portion of the overflow distributors **330, 335** and down the sides to form a uniform flow layer of appropriate thickness that will converge with the glass core layer **305** flow. The first cladding glass composition coats a first side of the glass core layer **305** to form a first cladding layer **310,** and the second cladding polymer composition coats a second side of the glass core layer **305** to form a second cladding layer **315.** Asymmetric layer thicknesses are achievable by adjusting the relative composition flow over the side of any given overflow distributor.

The double-sided overflow distributor **325** has a wedge-shaped forming member **340** associated therewith. The forming member **340** has converging sidewall portions which communicate at their top end with the sidewalls of the overflow distributor **325** and terminate at their converging bottom ends in a draw line. The molten core glass overflowing the overflow distributor **325** flows downwardly along the distributor walls and forms an initial glass flow layer adjacent to the converging outer surfaces of the forming member **340.** The two individual layers of core glass from each converging sidewall of the forming member **340** are brought together and fused to form the glass core layer **305,** which is located between the first cladding layer **310** and second cladding layer **315.** The molten first cladding composition overflows the overflow distributor **330** and flows downwardly over the distributor walls and over a first outer surface portion of the glass core layer **305,** thereby fusing together and creating a glass composite flow. The molten second cladding composition overflows the overflow distributor **335** and flows downwardly over the distributor walls and over a second outer surface portion of the glass core layer **305** to form a composite flow **320** that includes the first cladding layer **310,** the second cladding layer **315** and the glass core layer **305.** The dimensional control and resulting pristine glass surface conditions can make the fusion, or overflow process, a satisfactory method for making glass sealing sheets. For all the coating methods described above, the sheet-like flow of the glass core layer **305** is very reactive when in flowable or molten form, allowing the first cladding layer **310** and the second cladding layer **315** to form a strong bond with the surfaces of the glass core layer **305.**

Glass sealing sheets may be cut from the glass composite and transported for further processing. The glass sealing sheets comprise a glass core layer having a first side and a second side, a first cladding layer bonded to the first side of the glass core layer, and a second cladding layer bonded to the second side of the glass core layer.

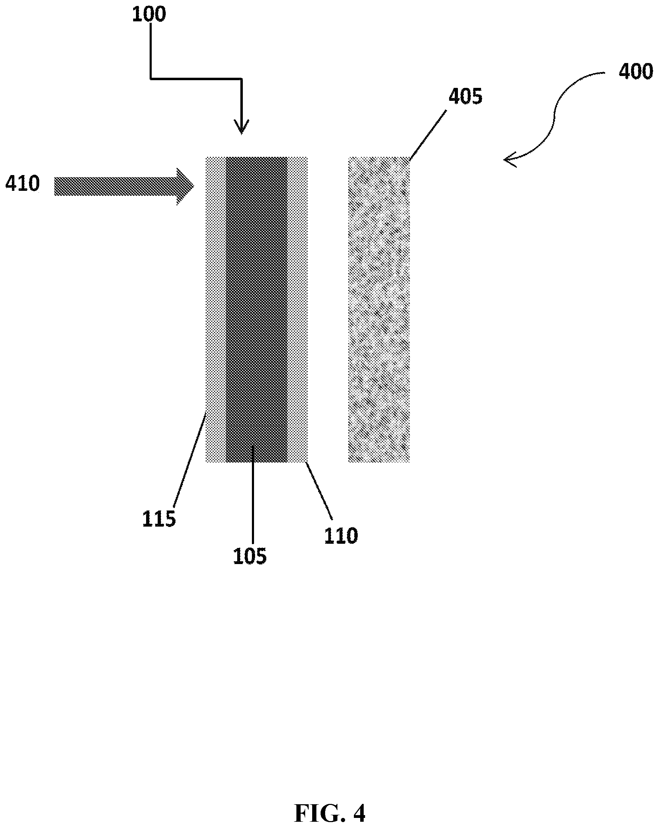

Referring to FIG. 4, depicted is a method **400** of manufacturing a glass package comprising placing the first cladding layer **110** of the glass sealing sheet **100** in contact with a glass substrate **405.** A laser **410** is used to irradiate a predetermined sealing area along the first cladding layer **110** of glass sealing sheet **100** to melt the first cladding layer **110.** The first cladding layer **110** forms a hermetically sealed glass package with the glass substrate **405** along the sealing area thereby binding the glass sealing sheet **100** to the glass substrate **405.** The glass package comprises a glass sealing sheet **100** and a glass substrate **405** sealed to the glass sealing sheet **100** such that a hermetic seal is substantially created.

In some embodiments, the glass substrate **405** may be at least partially transparent. However, this is not essential. The material of the glass substrate **405** is application driven. For example, the glass substrate **405** may comprise a borosilicate glass material. In some embodiments, the glass substrate **405** may be a transparent glass plate. Glass plates similar to those manufactured and sold by Corning Incorporated, such as Code 2916 glass or Eagle XG™ glass can be used. Other glass plates manufactured and sold by companies such as Asahi Glass Co. (e.g., OA10 glass and OA21 glass), Schott AG, Nippon Electric Glass Co., NHTechno and Samsung Corning Precision Glass Co. may also be used.

It may be beneficial for the material selected for the glass substrate **405** to be substantially non-absorbing of radiation at an emission wavelength of a laser or over emission wavelength ranges of lasers used to effect the sealing by heating of the glass sealing sheet **100.** In some embodiments, the glass substrate **405** may be substantially free of radiation absorbing constituents. In other embodiments, the glass substrate **405** may comprise radiation absorbing constituents having a wavelength or wavelength range that is essentially transparent to electromagnetic radiation emitted from a laser source used to seal the glass sealing sheet to a glass substrate.

The glass substrate **405** may have OLEDs and/or other circuitry deposited thereon. Of course, the methods and products of the exemplary embodiments disclosed herein may be used in other applications than those described. For example, the methods and products of the exemplary embodiments may be used in microreactor applications, where channels between plates of substantially inert material(s) (e.g., glass) can be used to introduce chemicals that form a reaction product(s). Furthermore, the methods and products of the illustrative embodiments may be used to provide sealing of a wide variety of thin film devices that require hermeticity, such as semiconductor thin-film devices.

In embodiments described herein, a laser **410** provides the electromagnetic radiation. However, this is not essential. The wavelength or wavelength range of the electromagnetic radiation used to effectuate sealing is chosen so as to not be substantially absorbed by (and thus significantly heat) the glass core layer **105** of the sealing sheet or the glass substrate **405;** especially if there is temperature sensitive material disposed on the glass substrate **405.**

The glass sealing sheet **100** is irradiated in a manner to heat a portion of the first cladding layer **110** along a predetermined sealing area. The laser **410** emits a laser beam through the second cladding layer **115** and the glass core layer **105** so that it is focused on the predetermined sealing area of the first cladding layer **110.** The sealing area melts as it is heated to form a hermetic seal that connects and bonds to the glass substrate **405** along the sealing area. The sealing area may be located along the edges of the glass substrate **405.** Other sealing area configurations may be used in order to maximize the sealed area of the device. For example, the sealing area may not have the same shape as the shape of the glass substrate **405.**

The glass sealing sheets described herein can be used for a variety of applications including, for example, for cover glass or glass backplane applications in consumer or commercial electronic devices including, for example, LCD, LED, OLED, and quantum dot displays, computer monitors, sound bars, and automated teller machines (ATMs); for touch screen or touch sensor applications, for portable electronic devices including, for example, mobile telephones, personal media players, and tablet computers; for integrated circuit applications including, for example, semiconductor wafers; for photovoltaic applications; for architectural glass applications; for automotive or vehicular glass applications including, for example, windows, lighting, instruments, and helmet visors; for commercial or household appliance applications; for lighting or signage (e.g., static or dynamic signage) applications; for transportation applications including, for example, rail and aerospace applications; or for antimicrobial applications.

A variety of products can incorporate the glass sealing sheets described herein. In some embodiments, an electronic device (e.g., a consumer or commercial electronic device) such as, for example, a LCD, LED, OLED, or quantum dot display comprises one or more of the glass sealing sheets, which can be deployed as a cover glass, or as a glass backplane. In some embodiments, an integrated circuit such as, for example, a semiconductor wafer, comprises one or more of the glass sealing sheets. In some embodiments, a lighting device (e.g., a LED or OLED) comprises one or more of the glass sealing sheets. In some embodiments, a photovoltaic cell comprises one or more of the glass sealing sheets. In some embodiments, an architectural pane comprises one or more of the glass sealing sheets. In some embodiments, a vehicular member or component such as, for example, a glazing or window, a light, or an instrument comprises one or more of the glass sealing sheets. In some embodiments, a helmet visor comprises one or more of the glass sealing sheets. In some embodiments, an appliance (e.g., a household or commercial appliance) comprises one or more of the glass sealing sheets. In some embodiments, a light or a sign comprises one or more of the glass sealing sheets.

It will be apparent to those skilled in the art that various modifications and variations can be made to the embodiments described herein without departing from the scope of the claimed subject matter. Thus, it is intended that the specification cover the modifications and variations of the various embodiments described herein provided such modification and variations come within the scope of the appended claims and their equivalents.

## Claims

1. A glass sealing sheet (100) comprising:
a glass core layer (105; 205; 305) having a first side and a second side; and
a first cladding layer (110; 210; 310) bonded to the first side of the glass core layer (105; 205; 305);
wherein the first cladding layer (110; 210; 310) has a first coefficient of thermal expansion and is formed from a glass composition comprising radiation absorbing constituents,
**characterised in that** the glass sealing sheet (100) further comprises a second cladding layer (115; 215; 315) bonded to the second side of the glass core layer (105; 205; 305);
**in that** the second cladding layer (115; 215; 315) is formed from a polymer composition comprising radiation absorbing constituents and has a second coefficient of thermal expansion;
**in that** a differential between the first coefficient of thermal expansion and the second coefficient of thermal expansion ranges from 0x10⁻⁷/°C to 10x10⁻⁷/°C; and
**in that** the radiation absorbing constituents comprise a transition metal or rare earth element, wherein the transition metal or rare earth element is selected from the group consisting of iron, copper, vanadium, manganese, cobalt, nickel, chromium, neodymium, and cerium.

2. The glass sealing sheet (100) of claim 1, wherein the glass core layer (105; 205; 305) has a core coefficient of thermal expansion that is from 0x10⁻⁷/°C to 50x10⁻⁷/°C greater than the first coefficient of thermal expansion and the second coefficient of thermal expansion.

3. The glass sealing sheet (100) of any of claims 1 - 2, wherein the glass composition of the first cladding layer (110; 210; 310) comprises:
from 50 mol.% to 75 mol.% SiO₂;
from 1 mol.% to 20 mol.% Al₂O₃;
from 8 mol.% to 30 mol.% B₂O₃;
from 0 mol.% to 6 mol.% Na₂O;
from 0 mol.% to 2 mol.% Li₂O;
from 0 mol.% to 3 mol.% K₂O;
from 0.5 mol.% to 5 mol.% radiation absorbing constituents; and
from 0 mol.% to 5 mol.% TiO₂.

4. The glass sealing sheet (100) of any preceding claim, wherein the first cladding layer (110; 210; 310) and the second cladding layer (115; 215; 315) have a thickness of from 30 microns to 150 microns.

5. The glass sealing sheet (100) of any preceding claim, wherein the glass sealing sheet (100) has a total thickness of less than about 1 mm.

6. The glass sealing sheet (100) of any preceding claim, wherein the first cladding layer (110; 210; 310) and the second cladding layer (115; 215; 315) have a compressive stress of from 20 MPa to 250 MPa.

7. A glass package comprising:
the glass sealing sheet (100) of claim 1; and
a glass substrate (405) sealed to the glass sealing sheet (100) such that a hermetic seal is substantially created.

8. A method of manufacturing a glass package, the method comprising:
placing a glass sealing sheet (100) according to claim 1 in contact with a glass substrate (405); and
irradiating a predetermined sealing area along the first cladding layer (110; 210; 310) with a laser (410) to form a hermetically sealed glass package.

9. The method of claim 8, wherein radiation from the laser (410) is directed through the second cladding layer (115; 215; 315) and the glass core layer (105; 205; 305) and focused on the predetermined sealing area along the first cladding layer (110; 210; 310).

10. A method of manufacturing a glass sealing sheet (100), the method comprising:
melting a core glass composition to form a molten core glass composition;
melting a first cladding glass composition comprising radiation absorbing constituents to form a molten first cladding glass composition;
melting a second cladding polymer composition to form a molten second cladding polymer composition comprising radiation absorbing constituents;
flowing the molten core glass composition, the molten first cladding glass composition, and the molten second cladding polymer composition such that they converge and form a composite flow; and
drawing the composite flow into a glass sealing sheet (100) comprising:
a glass core layer (105; 205; 305) having a first side and a second side, the glass core layer (105; 205; 305) having a core coefficient of thermal expansion,
a first cladding layer (110; 210; 310) having a first coefficient of thermal expansion bonded to the first side of the glass core layer (105; 205; 305), and
a second cladding layer (115; 215; 315) bonded to the second side of the glass core layer (105; 205; 305), the second cladding layer (115; 215; 315) having a second coefficient of thermal expansion;
wherein a differential between the first coefficient of thermal expansion and the core coefficient of thermal expansion ranges from 0x10⁻⁷/°C to 10x10⁻⁷/°C; and
wherein the radiation absorbing constituents comprise a transition metal or rare earth element, wherein the transition metal or rare earth element is selected from the group consisting of iron, copper, vanadium, manganese, cobalt, nickel, chromium, neodymium, and cerium.

## Patentansprüche

1. Glasdichtungslage (100), umfassend:
eine Glaskernschicht (105; 205; 305), die eine erste Seite und eine zweite Seite aufweist; und
eine erste Mantelschicht (110; 210; 310), die an die erste Seite der Glaskernschicht (105; 205; 305) gebunden ist;
wobei die erste Mantelschicht (110; 210; 310) einen ersten Wärmeausdehnungskoeffizienten aufweist und aus einer Glaszusammensetzung gebildet ist, die strahlungsabsorbierende Bestandteile umfasst,
**dadurch gekennzeichnet, dass** die Glasdichtungslage (100) ferner eine zweite Mantelschicht (115; 215; 315) umfasst, die an die zweite Seite der Glaskernschicht (105; 205; 305) gebunden ist;
dass die zweite Mantelschicht (115; 215; 315) aus einer Polymerzusammensetzung gebildet ist, die strahlungsabsorbierende Bestandteile umfasst und einen zweiten Wärmeausdehnungskoeffizienten aufweist;
dass eine Differenz zwischen dem ersten Wärmeausdehnungskoeffizienten und dem zweiten Wärmeausdehnungskoeffizienten im Bereich von 0x10⁻⁷/°C bis 10x10⁻⁷/°C liegt; und
dass die strahlungsabsorbierenden Bestandteile ein Übergangsmetall oder ein Seltenerdelement umfassen, wobei das Übergangsmetall oder das Seltenerdelement aus der Gruppe ausgewählt ist, die aus Eisen, Kupfer, Vanadium, Mangan, Kobalt, Nickel, Chrom, Neodym und Cer besteht.

2. Glasdichtungslage (100) nach Anspruch 1, wobei die Glaskernschicht (105; 205; 305) einen Kernwärmeausdehnungskoeffizienten aufweist, der 0x10⁻⁷/°C bis 50x10⁻⁷/°C größer als der erste Wärmeausdehnungskoeffizient und der zweite Wärmeausdehnungskoeffizient ist.

3. Glasdichtungslage (100) nach einem der Ansprüche 1 bis 2, wobei die Glaszusammensetzung der ersten Mantelschicht (110; 210; 310) Folgendes umfasst:
50 Mol-% bis 75 Mol-% SiO₂,
1 Mol-% bis 20 Mol-% Al₂O₃;
8 Mol-% bis 30 Mol-% B₂O₃;
0 Mol-% bis 6 Mol-% Na₂O;
0 Mol-% bis 2 Mol-% Li₂O;
0 Mol-% bis 3 Mol-% K₂O;
0,5 Mol-% bis 5 Mol-% strahlungsabsorbierende Bestandteile; und
0 Mol-% bis 5 Mol-% TiO₂.

4. Glasdichtungslage (100) nach einem vorhergehenden Anspruch, wobei die erste Mantelschicht (110; 210; 310) und die zweite Mantelschicht (115; 215; 315) eine Dicke von 30 Mikrometern bis 150 Mikrometern aufweisen.

5. Glasdichtungslage (100) nach einem vorhergehenden Anspruch, wobei die Glasdichtungslage (100) eine Gesamtdicke von weniger als etwa 1 mm aufweist.

6. Glasdichtungslage (100) nach einem vorhergehenden Anspruch, wobei die erste Mantelschicht (110; 210; 310) und die zweite Mantelschicht (115; 215; 315) eine Druckspannung von 20 MPa bis 250 MPa aufweisen.

7. Glasverpackung, umfassend:
die Glasdichtungslage (100) nach Anspruch 1; und
ein Glassubstrat (405), das mit der Glasdichtungslage (100) derart abgedichtet ist, dass im Wesentlichen eine hermetische Dichtung erzeugt wird.

8. Verfahren zur Herstellung einer Glasverpackung, wobei das Verfahren Folgendes umfasst:
Platzieren einer Glasdichtungslage (100) nach Anspruch 1 in Kontakt mit einem Glassubstrat (405); und
Bestrahlen eines vorbestimmten Dichtungsbereichs entlang der ersten Mantelschicht (110; 210; 310) mit einem Laser (410), um eine hermetisch abgedichtete Glasverpackung zu bilden.

9. Verfahren nach Anspruch 8, wobei Strahlung von dem Laser (410) durch die zweite Mantelschicht (115; 215; 315) und die Glaskernschicht (105; 205; 305) gerichtet und auf den vorbestimmten Dichtungsbereich entlang der ersten Mantelschicht (110; 210; 310) fokussiert wird.

10. Verfahren zur Herstellung einer Glasdichtungslage (100), wobei das Verfahren Folgendes umfasst:
Schmelzen einer Kernglaszusammensetzung, um eine geschmolzene Kernglaszusammensetzung zu bilden;
Schmelzen einer ersten Mantelglaszusammensetzung, die strahlungsabsorbierende Bestandteile umfasst, um eine geschmolzene erste Mantelglaszusammensetzung zu bilden;
Schmelzen einer zweiten Mantelpolymerzusammensetzung, um eine geschmolzene zweite Mantelpolymerzusammensetzung, die strahlungsabsorbierende Bestandteile umfasst, zu bilden;
Fließenlassen der geschmolzenen Kernglaszusammensetzung, der geschmolzenen ersten Mantelglaszusammensetzung und der geschmolzenen zweiten Mantelpolymerzusammensetzung, sodass sie konvergieren und einen Verbundfluss bilden; und
Ziehen des Verbundflusses in eine Glasdichtungslage (100), umfassend:
eine Glaskernschicht (105; 205; 305), die eine erste Seite und eine zweite Seite aufweist, wobei die Glaskernschicht (105; 205; 305) einen Kernwärmeausdehnungskoeffizienten aufweist,
eine erste Mantelschicht (110; 210; 310), die einen ersten Wärmeausdehnungskoeffizienten aufweist, die an die erste Seite der Glaskernschicht (105; 205; 305) gebunden ist, und
eine zweite Mantelschicht (115; 215; 315), die an die zweite Seite der Glaskernschicht (105; 205; 305) gebunden ist, wobei die zweite Mantelschicht (115; 215; 315) einen zweiten Wärmeausdehnungskoeffizienten aufweist;
wobei eine Differenz zwischen den ersten Wärmeausdehnungskoeffizienten und dem Kernwärmeausdehnungskoeffizienten im Bereich von 0x10⁻⁷/°C bis 10x10⁻⁷/°C liegt; und
wobei die strahlungsabsorbierenden Bestandteile ein Übergangsmetall oder ein Seltenerdelement umfassen, wobei das Übergangsmetall oder das Seltenerdelement aus der Gruppe ausgewählt ist, die aus Eisen, Kupfer, Vanadium, Mangan, Kobalt, Nickel, Chrom, Neodym und Cer besteht.

## Revendications

1. Feuille d'étanchéité de verre (100) comprenant :
une couche centrale de verre (105, 205, 305) possédant un premier côté et un second côté ; et une première couche de revêtement (110, 210, 310) liée au premier côté de la couche centrale de verre (105, 205, 305) ;
la première couche de revêtement (110, 210, 310) possédant un premier coefficient de dilatation thermique et étant formée à partir d'une composition de verre comprenant des constituants absorbant des rayonnements, **caractérisé en ce que** la feuille d'étanchéité de verre (100) comprend en outre une seconde couche de revêtement (115, 215, 315) liée au second côté de la couche centrale de verre (105, 205, 305) ;
**en ce que** la second couche de revêtement (115, 215, 315) est formée à partir d'une composition polymère comprenant des constituants absorbant des rayonnements et possède un second coefficient de dilatation thermique ;
**en ce qu'**une différence entre le premier coefficient de dilatation thermique et le second coefficient de dilatation thermique est comprise dans la plage allant de 0x10⁻⁷/°C à 10x10⁻⁷/°C ; et **en ce que** les constituants absorbant des rayonnements comprennent un métal de transition ou une terre rare, ledit métal de transition ou ladite terre rare étant choisi dans le groupe constitué par le fer, le cuivre, le vanadium, le manganèse, le cobalt, le nickel, le chrome, le néodyme et le cérium.

2. Feuille d'étanchéité de verre (100) selon la revendication 1, ladite couche centrale de verre (105, 205, 305) possédant un coefficient de dilatation thermique central qui va de 0x10⁻⁷/°C à 50x10⁻⁷/°C supérieur au premier coefficient de dilatation thermique et au second coefficient de dilatation thermique.

3. Feuille d'étanchéité de verre (100) selon l'une quelconque des revendications 1 à 2, ladite composition de verre de la première couche de revêtement (110, 210, 310) comprenant :
de 50 % en mole à 75 % en mole de SiO₂ ;
de 1 % en mole à 20 % en mole d'Al₂O₃ ;
de 8 % en mole à 30 % en mole de B₂O₃ ;
de0 % en mole à 6 % en mole de Na₂O ;
de 0 % en mole à 2 % en mole de Li₂O ;
de 0 % en mole à 3 % en mole de K₂O ;
de 0,5 % en mole à 5 % en mole de constituants absorbant des rayonnements ; et
de 0 % en mole à 5 % en mole de TiO₂.

4. Feuille d'étanchéité de verre (100) selon l'une quelconque des revendications précédentes, ladite première couche de revêtement (110, 210, 310) et ladite seconde couche de revêtement (115, 215, 315) possédant une épaisseur allant de 30 microns à 150 microns.

5. Feuille d'étanchéité de verre (100) selon l'une quelconque des revendications précédentes, ladite feuille d'étanchéité de verre (100) possédant une épaisseur totale inférieure à environ 1 mm.

6. Feuille d'étanchéité de verre (100) selon l'une quelconque des revendications précédentes, ladite première couche de revêtement (110, 210, 310) et ladite seconde couche de revêtement (115, 215, 315) possédant une contrainte de compression allant de 20 MPa à 250 MPa.

7. Emballage de verre comprenant :
la feuille d'étanchéité de verre (100) selon la revendication 1 ; et
un substrat de verre (405) scellé à la feuille d'étanchéité de verre (100) de sorte qu'un joint d'étanchéité hermétique soit sensiblement créé.

8. Procédé de fabrication d'un emballage de verre, le procédé comprenant :
la mise en place d'une feuille d'étanchéité de verre (100) selon la revendication 1 en contact avec un substrat de verre (405) ; et
l'irradiation d'une zone d'étanchéité prédéfinie le long de la première couche de revêtement (110, 210, 310) avec un laser (410) pour former un emballage de verre hermétiquement scellé.

9. Procédé selon la revendication 8, ledit rayonnement provenant du laser (410) étant dirigé à travers la seconde couche de revêtement (115, 215, 315) et la couche centrale de verre (105, 205, 305) et étant focalisé sur la zone d'étanchéité prédéfinie le long de la première couche de revêtement (110, 210, 310).

10. Procédé de fabrication d'une feuille d'étanchéité de verre (100), le procédé comprenant :
la fusion d'une composition de verre centrale pour former une composition de verre centrale fondue ;
la fusion d'une première composition de verre de revêtement comprenant des constituants absorbant des rayonnements pour former une première composition de verre de revêtement fondue ;
la fusion d'une seconde composition polymère de revêtement pour former une seconde composition polymère de revêtement fondue comprenant des constituants absorbant des rayonnements ;
l'écoulement de la composition de verre centrale fondue, de la première composition de verre de revêtement fondue et de la seconde composition polymère de revêtement fondue de sorte qu'elles convergent et forment un écoulement composite ; et
l'étirement du flux composite dans une feuille d'étanchéité de verre (100) comprenant :
une couche centrale de verre (105, 205, 305) possédant un premier côté et un second côté, la couche centrale de verre (105, 205, 305) possédant un coefficient de dilatation thermique central,
une première couche de revêtement (110, 210, 310) possédant un premier coefficient de dilatation thermique lié au premier côté de la couche centrale de verre (105, 205, 305) et
une seconde couche de revêtement (115, 215, 315) liée au second côté de la couche centrale de verre (105, 205, 305), la seconde couche de revêtement (115, 215, 315) possédant un second coefficient de dilatation thermique ;
une différence entre le premier coefficient de dilatation thermique et le coefficient de dilatation thermique central étant comprise dans la plage allant de 0x10⁻⁷/°C et 10x10⁻⁷/°C ; et
lesdits constituants absorbant des rayonnements comprenant un métal de transition ou une terre rare, ledit métal de transition ou ladite terre rare étant choisi dans le groupe constitué par le fer, le cuivre, le vanadium, le manganèse, le cobalt, le nickel, le chrome, le néodyme et le cérium.
